# FASCICULE DE BREVET EUROPEEN

(11) **EP 0 702 850 B1**
(45) Date de publication et mention de la délivrance du brevet: **10.12.1997**
(21) Numéro de dépôt: 95916724.8
(22) Date de dépôt: 07.04.1995
(51) Int. Cl.: H01L 27/146

(54) **COMPOSANT HYBRIDE SEMICONDUCTEUR**
HYBRIDE HALBLEITERANORDNUNG
HYBRID SEMICONDUCTOR COMPONENT

(30) Priorité: 08.04.1994 FR 9404168; 21.06.1994 FR 9407573
(43) Date de publication de la demande: 27.03.1996
(73) Titulaire: THOMSON-CSF, 75008 Paris (FR)
(72) Inventeur: DUBOZ, Jean-Yves, F-92402 Courbevoie Cédex (FR); ROSENCHER, Emmanuel, F-92402 Courbevoie Cédex (FR); BOIS, Philippe, F-92402 Courbevoie Cédex (FR)
(74) Mandataire: Guérin, Michel
(86) Numéro de dépôt international: FR9500448
(87) Numéro de publication internationale: WO9528006

(56) Documents cités:
- US-A- 4 783 594
- US-A- 5 236 871
- US-A- 5 300 777
- IEEE TRANSACTIONS ON ELECTRON DEVICES, FEB. 1993, USA, vol. 40, no. 2, ISSN 0018-9383, pages 320-324, MANTESE J V ET AL 'Infrared imaging using uncooled focal plane arrays of unreticulated 10- mu m potassium tantalum niobate films'

## Description

Le domaine de l'invention est celui des composants semiconducteurs et notamment mais non exclusivement celui des détecteurs infrarouges.

Actuellement, il existe des détecteurs infrarouges réalisés à partir de matériaux semiconducteurs tels que des composés III-V (GaAs, InP notamment), IV-VI (tel que PbTe) ou II-VI (tel que HgCdTe) présentant de très bonnes performances en détection. Néanmoins, ces matériaux ne conviennent pas pour réaliser aisément des circuits de lecture des charges photoélectriques détectées ou des circuits de traitement des signaux issus de cette lecture. Ces circuits doivent plutôt être réalisés à partir de silicium, dont la technologie est maintenant bien maîtrisée et donc peu coûteuse. C'est pourquoi, aussi bien pour des détecteurs infrarouge que pour d'autres fonctions, on a essayé de développer des dispositifs mixtes silicium/autre matériau semiconducteur.

Des tentatives ont été faites en particulier pour déposer de l'arséniure de gallium sur un substrat de silicium : les couches à base d'arséniure de gallium, déposées sur une partie du substrat de silicium, servent à former les éléments actifs qui ne peuvent être réalisés avec du silicium; le reste du substrat est utilisé pour réaliser des circuits de lecture et de traitement à base de silicium. Mais cette solution, bien qu'envisageable pour l'arséniure de gallium, est difficile à mettre en oeuvre et ne convient d'ailleurs pas à d'autres matériaux de détection infrarouge tels que HgCdTe ou PbTe.

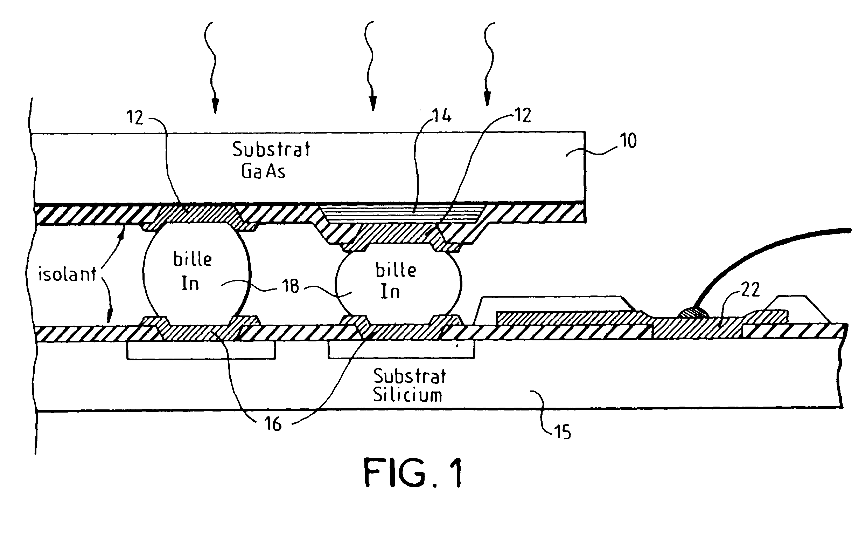

Une autre solution, actuellement largement utilisée industriellement, consiste à faire un montage hybride regroupant un composant intégré sur un substrat de silicium et un composant intégré sur un substrat en matériau différent (AsGa, InP, HgCdTe, PbTe). Dans le cas de détecteurs infrarouge, la technologie d'hybridation la plus utilisée consiste à utiliser comme substrat principal d'hybridation un substrat de silicium sur lequel sont intégrés des circuits de lecture et de traitement électronique, et à souder sur ce circuit intégré, face contre face, un circuit de détection, formé sur un substrat autre que du silicium et comportant les éléments photosensibles. La figure 1 représente un tel montage dans le cas classique d'une hybridation par billes d'indium, une telle structure est par exemple décrite dans US-A-4783594 et US-A-5300777. Le circuit de détection (substrat 10 en matériau tel que AsGa par exemple) comporte des plots de contact 12 reliés à des éléments photosensibles 14; le substrat de silicium 15 comporte des plots de contact 16 reliés à des entrées correspondantes des circuits de lecture formés sur ce substrat. Les plots des deux composants intégrés sont disposés exactement en regard les uns des autres et sont soudés ensemble par l'intermédiaires de billes d'indium 18. L'hybridation des deux substrats se fait donc par une soudure de l'ensemble des plots de contact en vis-à-vis, cette soudure établissant à la fois la liaison mécanique des deux substrats et la liaison électrique point par point entre chacun des éléments photosensibles et leurs circuits de lecture respectifs. Le substrat de silicium, substrat principal de l'hybridation, comporte par ailleurs des plots de contact d'entrée/sortie 22 pour la liaison avec l'extérieur.

Cette technique d'hybridation présente néanmoins des limites. En effet, il existe une grande différence entre les coefficients de dilatation thermique du silicium et ceux des autres semiconducteurs. Or, alors que l'hybridation est réalisée au-dessus de la température ambiante, les éléments actifs (type détecteur infrarouge) sont destinés à fonctionner à très basses températures (autour de 77°Kelvin) ; l'indium est d'ailleurs choisi pour sa grande capacité à absorber les contraintes qui se produisent lors du passage de la température ambiante à la très basse température d'utilisation. Mais même si les contraintes mécaniques sont réduites, les différences de coefficient de dilatation des deux substrats subsistent et entraînent que des plots de contact qui sont en vis-à-vis sur les deux substrats à une température donnée peuvent ne plus l'être à une autre température. C'est le cas lorsque des contacts sont très rapprochés. Ceci peut provoquer des court-circuits ou d'autres défauts rendant impossible un fonctionnement correct du composant.

Pour éviter cet inconvénient on est donc obligé de limiter fortement les dimensions du substrat portant les éléments de détection. La plupart du temps, la taille des barrettes de détection infrarouge ne peut dans ces conditions dépasser environ 10 mm. Si on souhaite réaliser des barrettes plus longues, on doit alors rabouter plusieurs barrettes de quelques millimètres chacune sur le substrat principal de silicium. Ce raboutage introduit cependant des zones dépourvues de détecteurs (pixels manquants dans l'image explorée), ce qui n'est pas souhaitable.

Une autre limitation de cette technologie d'hybridation se trouve être dans la taille des billes d'indium qui doit être suffisante (plusieurs dizaines de micromètre de largeur) pour permettre une soudure correcte entre les deux substrats. Cette taille est difficilement compatible avec l'utilisation d'un grand nombre de contacts très rapprochés entre les deux substrats : par exemple on ne peut pas employer cette technologie pour des barrettes de photodiodes de haute résolution comportant de nombreux éléments de détection et des contacts au dessus de ces éléments (cas classique) : si les plots de contact doivent être répartis sur une ligne de 10 millimètres au maximum avec un pas de 60 micromètres, on ne peut guère aller au delà de 150 éléments sur la barrette. Cette technologie est donc difficilement utilisable lorsque l'on cherche à densifier au maximum les fonctions actives sur des substrats semiconducteurs dont la taille est par ailleurs limitée par suite des contraintes thermiques.

On a également essayé de rapporter les barrettes de photodiodes ainsi que les puces de silicium sur un substrat intermédiaire ayant un coefficient de dilatation thermique intermédiaire entre celui du silicium et celui du substrat portant les éléments actifs. On limite ainsi partiellement mais pas suffisamment les problèmes dus aux coefficients de dilatation différents.

Pour résoudre ces différents problèmes, l'invention propose un nouveau type de composant semiconducteur hybride dont l'originalité est qu'il comporte plusieurs circuits intégrés de silicium de taille limitée, rapportés sur un substrat plus grand (en matériau différent du silicium) sur lequel sont intégrés les éléments actifs qui ne peuvent être réalisés sur un substrat de silicium. Le nombre et le pas de ces éléments actifs n'est alors plus limité par les problèmes de dilatation différentielle ni par les contraintes liées aux billes d'indium; pour des détecteurs infrarouge notamment il devient possible de réaliser des barrettes de haute résolution et de grande longueur, d'un seul tenant (sans opération d'aboutage).

Le composant semiconducteur hybride selon l'invention comprend un substrat principal en matériau autre que du silicium, dans lequel sont intégrés d'une part des éléments actifs, d'autre part des premiers plots de contact et des connexions entre chaque élément actif et un plot de contact respectif, et plusieurs puces de circuit intégré en silicium dans lesquelles sont intégrés d'une part des circuits électroniques destinés à être reliés aux éléments actifs du substrat principal, et d'autre part des seconds plots de contact en regard de ceux du substrat principal, les puces de silicium étant soudées sur le substrat principal par l'intermédiaire desdits premiers et seconds plots de contact en regard.

Le matériau du substrat principal sera le plus souvent un matériau semiconducteur, notamment pris parmi les classes III-V, II-VI ou IV-VI, et tout particulièrement GaAs, InP, PbTe, HgCdTe.

L'invention est en effet particulièrement intéressante pour la réalisation de barrettes linéaires ou multilinéaires de détection de rayonnement, infrarouge notamment. Elle est très avantageusement utilisée pour des détecteurs du type destiné à être refroidis à très basse température. Les puces de silicium peuvent être des puces de quelques millimètres de côté, dimensions pour lesquelles les contraintes de dilatation thermique différentielle restent acceptables et qui permettent cependant déjà d'intégrer des fonctions électroniques nombreuses et complexes : fonctions de lecture de charges issues de groupes de plusieurs éléments photosensibles, fonctions de multiplexage des signaux issus de cette lecture.

Les plots de contact du substrat principal portant les éléments actifs photosensibles sont de préférence déportés par rapport à ces éléments de sorte qu'ils peuvent avoir une taille et un pas d'espacement plus grand que la taille et le pas d'espacement des éléments actifs. On pourra prévoir aussi que les puces de silicium, soudées à ces contacts déportés, ne recouvrent pas les éléments actifs photosensibles, de manière à permettre un éclairement de ces détecteurs par la face avant du premier substrat (celle qui porte les puces de silicium et les éléments actifs). Dans les techniques antérieures d'hybridation par billes d'indium, l'éclairement doit se faire nécessairement par la face arrière, ce qui oblige à utiliser des techniques d'amincissement du substrat portant les éléments photosensibles. Ces techniques sont coûteuses et entraînent des baisses de rendement de fabrication.

L'invention sera mieux comprise grâce à la description qui va suivre, donnée à titre non limitatif, et grâce aux figures annexées parmi lesquelles :
- la figure 1, déjà décrite représente un composant hybride selon l'art connu, utilisant un substrat principal de silicium ;
- la figure 2 représente le principe de l'invention consistant à placer plusieurs circuits de silicium sur un substrat principal en matériau différent;
- la figure 3 illustre un composant selon l'invention en vue de dessus ;
- la figure 4 illustre le principe d'un composant de haute résolution avec des éléments actifs de taille et de pas beaucoup plus petits que la taille et le pas des plots de contact d'hybridation;
- la figure 5 représente en coupe un détail de détecteur infrarouge pouvant être éclairé par la face avant.

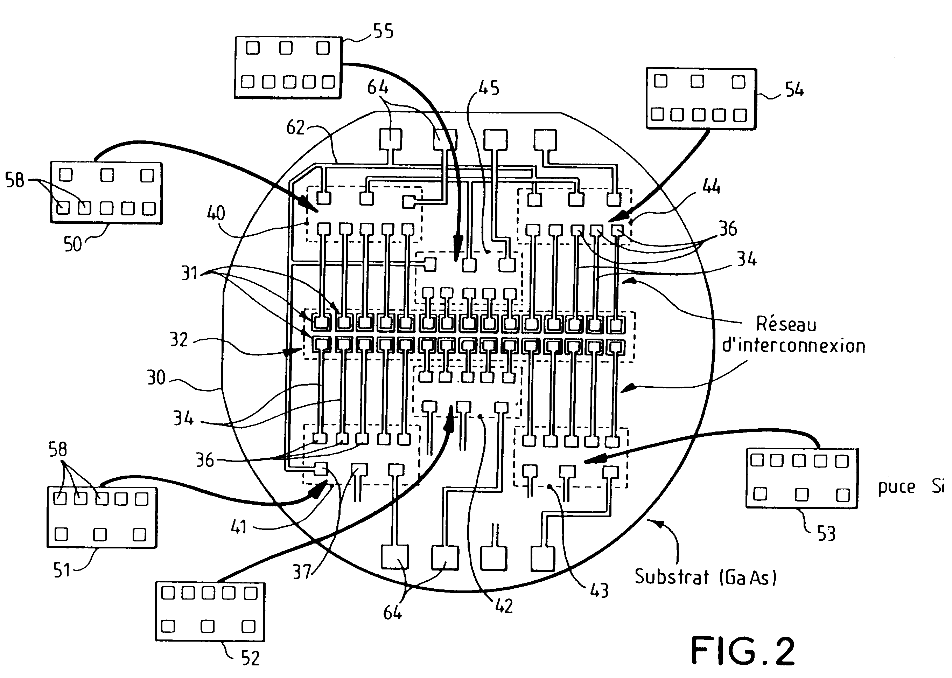

La figure 2 représente en vue de dessus, le principe de l'invention. Dans les techniques classiques d'hybridation utilisées pour des détecteurs infrarouge linéaires, multilinéaires ou matriciels, le substrat principal d'hybridation était le substrat de silicium sur lequel on soudait le circuit de détection comportant les éléments photosensibles (cf. figure 1). Ici, le substrat principal d'hybridation est le substrat qui porte les éléments actifs; il n'est pas en silicium du fait que les éléments actifs ne peuvent pas être réalisés, ou pas facilement réalisés, sur un substrat de silicium. Par "substrat principal", on entend ici celui qui comporte des plots de connexion du composant hybride vers l'extérieur. Par "élément actif' on entend ici des éléments autres que de simples connexions conductrices; pour un détecteur de rayonnement les éléments actifs sont les éléments photosensibles, qui peuvent être des photodiodes par exemple.

Le substrat principal 30 est représenté ici comme une tranche entière circulaire d'arséniure de gallium (GaAs), par exemple une tranche de 3 pouces c'est-à-dire 7,5 cm de diamètre, mais bien entendu le substrat principal peut être une puce rectangulaire découpée dans une tranche. Le substrat peut aussi être en phosphure d'indium (InP), en HgCdTe, ou en PbTe, etc., selon le type de rayonnement qu'on cherche à détecter.

Les éléments photosensibles 31 sont directement intégrés dans ce substrat principal, selon des techniques de diffusions, dépôts, masquages, gravures sélectives ou non sélectives habituelles dans la fabrication de semiconducteurs intégrés. La zone dans laquelle sont intégrés ces éléments photosensibles est entourée d'un trait tireté 32 sur la figure 2. Des connexions conductrices 34, réalisées en principe par dépôt et gravure d'une couche métallique, sont également intégrées sur le substrat 30. Ces connexions relient individuellement les éléments photosensibles 31 à des plots de contact 36 qui sont déportés latéralement par rapport à ces éléments. Ces plots de contact sont répartis en groupes dans plusieurs zones différentes 40, 41, 42, 43, 44, 45 du substrat principal 30. Chaque zone correspond à l'emplacement d'un circuit intégré de silicium respectif 50, 51, 52, 53, 54, 55 à souder sur le substrat principal. Les puces de circuit intégré de silicium sont représentées à côté du substrat principal 30. Elles sont représentées face avant visible mais sont destinées à être retournées pour être soudées par leur face avant contre le substrat principal. Elles comportent sur cette face avant des plots de contact 58 dont les positions correspondent exactement, après retoumement de la puce, à celles des plots de contact des zones 40 à 45. Les puces de silicium comportent des circuits électroniques, et notamment, dans le cas de détecteurs infrarouges, des circuits de lecture et de multiplexage permettant de lire individuellement et de transmettre séquentiellement sur les sorties du composant hybride des signaux représentant les éclairements individuellement reçus par chacun des éléments photosensibles 31. En principe, chaque élément photosensible 31 du substrat principal 30 est relié à un circuit de lecture respectif d'une puce de silicium. Les éléments actifs photosensibles sont tous situés sur le substrat principal unique, mais les circuits de lecture sont répartis sur les différentes puces de silicium.

Parmi les plots de contact des zones 40 à 45 du substrat 30, il y a non seulement les plots 36 reliés aux éléments actifs 31, mais également des plots 37 reliés à d'autres connexions 62 intégrées sur le substrat principal 30. Ces autres connexions vont soit vers des plots de contact d'entrée/sortie 64, situés en dehors des zones 40 à 45 et de la zone 32 et servant à la connexion du composant avec l'extérieur, soit vers d'autres puces de silicium. Les plots d'entrée/sortie 64 peuvent servir par exemple d'emplacement de soudure pour recevoir des fils souples qui les relient à des bornes de connexion d'un boîtier contenant le composant hybride. On peut prévoir que certaines puces de silicium sont reliées par des connexions 62 à d'autres puces de silicium, sans être reliées aux éléments photosensibles. Ce serait le cas par exemple pour une puce de silicium servant uniquement à multiplexer les signaux issus des autres puces, ces dernières contenant chacune des circuits de lecture d'un groupe limité d'éléments photosensibles et des circuits de multiplexage limités à ce groupe d' éléments.

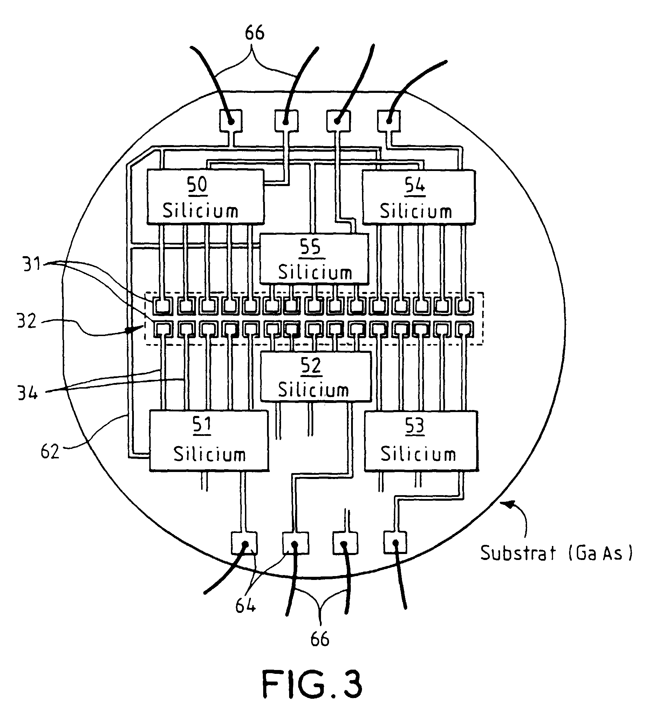

Le composant semiconducteur hybride réalisé par cette technique est représenté à la figure 3. Les puces de silicium retournées sont soudées par leur face avant sur la face avant du substrat principal 30, de préférence par l'intermédiaire de billes d'indium. Les billes d'indium sont réalisées classiquement en déposant une couche d'indium sur un substrat revêtu d'une couche isolante ouverte uniquement au dessus des plots de contact. Le substrat est ensuite chauffé et les forces de tension superficielles concentrent l'indium en gouttes localisées sur les plots de contact.

Sur la figure 3, les fils de connexion avec l'extérieur sont désignés par la référence 66. Le boîtier du composant hybride n'est pas représenté.

Les puces de silicium ne recouvrent pas les contacts d'entrée/sortie 64. Si elles ne recouvrent pas non plus la zone photosensible 32, on peut envisager, contrairement au cas habituel, que le composant détecteur infrarouge soit éclairé par sa face avant, c'est-à-dire la face où sont intégrés les éléments photosensibles 31. Il n'est donc pas nécessaire alors d'amincir le substrat en AsGa ou InP ou HgCdTe, PbTe, etc. L'amincissement est une cause de fragilité et de perte de rendement. Cependant, si on réalise ainsi un composant de détection à éclairer par la face avant, il faut faire en sorte que les connexions métalliques 34 ne masquent pas les éléments photosensibles; des conducteurs transparents aux longueurs d'onde détectées doivent être utilisés, ou alors les prises de contact sur ces éléments doivent occuper une faible proportion de la surface utile de ces éléments.

Sur la représentation schématique de la figure 2, on a supposé que les plots de contact 36 avaient des dimensions et un pas d'espacement identiques à ceux des éléments actifs 31. Mais l'invention est particulièrement intéressante en ce qu'elle permet de réduire beaucoup la taille et le pas des éléments photosensibles par rapport à ce qu'ils étaient dans l'art antérieur.

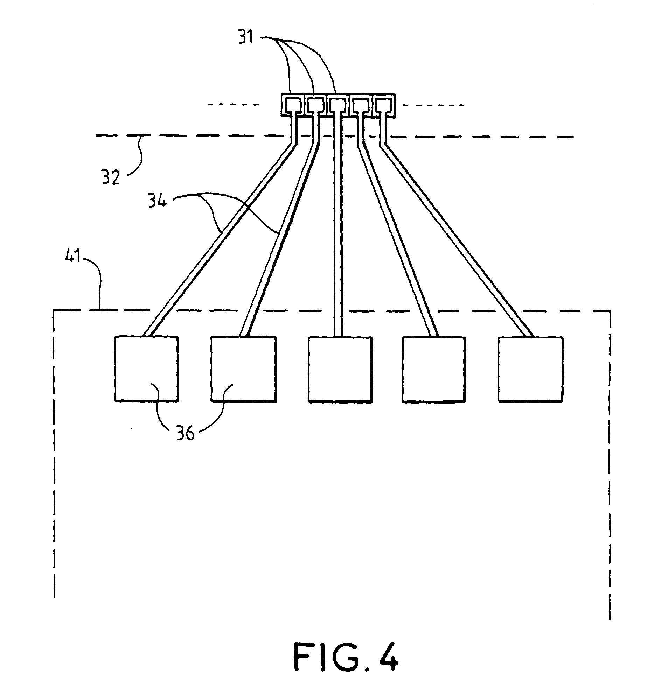

C'est ce que montre la figure 4, dans laquelle on a prévu que la taille et le pas des pixels photosensibles 31 sont beaucoup plus petites que la taille et le pas des plots de contact 36 auxquels ils sont raccordés. Les dimensions de plots de contact 36 sont de préférence d'au moins 25 à 30 micromètres de large (ce qui est en général nécessaire pour une soudure par billes d'indium). Ils sont répartis en groupes, chaque groupe correspondant à une puce de silicium respective à souder à ces plots. Les éléments photosensibles peuvent cependant rester tous alignés à un pas constant, plus petit, et même beaucoup plus petit, que le pas des plots de contact 36.

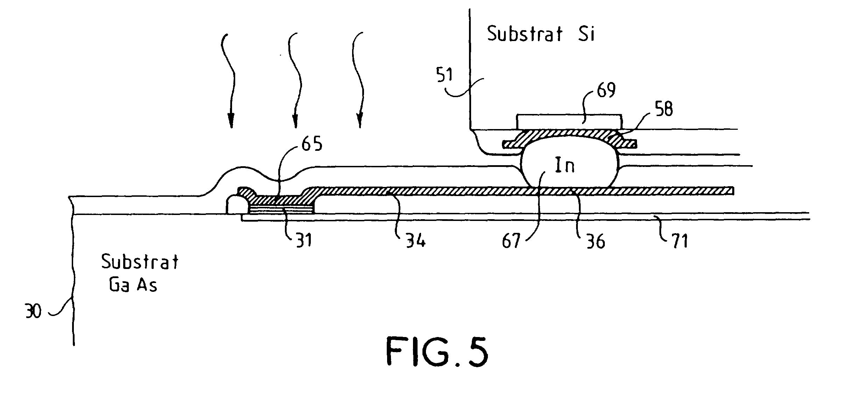

La figure 5 représente en coupe un détail de réalisation : on y voit le substrat principal d'hybridation 30 en AsGa ou InP, un élément photosensible 31 constitué par des couches à base d'arséniure de gallium, un contact métallique supérieur 65 permettant de connecter l'élément photosensible 31 à un plot de contact 36 et donc à une puce de silicium 51 par l'intermédiaire d'une connexion métallique 34; une bille d'indium 67 entre le plot 36 et un plot 58 de la puce de silicium. Les circuits de lecture de la puce de silicium, réalisés selon les techniques habituelles en microélectronique, sont symbolisés par une diffusion 69 dans le silicium; une couche de contact inférieure 71, diffusée en surface du substrat 30, permet d'accéder à l'arrière de l'élément photosensible 31 qui est en général une photodiode nécessitant un contact supérieur et un contact inférieur. Cette couche inférieure 71 peut être commune à tous les éléments photosensibles du substrat 30 et être reliée par un contact non représenté aux circuits de silicium et à un plot d'entrée/sortie du composant. Enfin, diverses couches isolantes sont en général nécessaires sur le substrat 30 et sur les puces de silicium pour l'élaboration du composant par des techniques de microélectronique habituelles.

Un seul niveau de métallisation est représenté sur la figure 5. Cependant, on comprendra que si les interconnexions entre le substrat principal 30 et les puces de silicium sont nombreuses, des croisements de connexions seront inévitables et nécessiteront plusieurs niveaux de métallisation séparées par des couches isolantes.

Le composant semiconducteur hybride selon l'invention permet l'utilisation de dispositifs linéaires semiconducteurs en matériau autre que du silicium, de longueurs largement supérieures à une dizaine de mm, sans raboutage, à partir du moment où l'on dispose d'un substrat semiconducteur correspondant de surface suffisante.

A partir d'un substrat d'AsGa par exemple dont le diamètre peut atteindre 7,5 centimètres (3 pouces), il est possible de réaliser une barrette de détection infrarouge linéaire ou multilinéaire de plusieurs centimètres de long, et de haute résolution (plus de mille points par ligne), en montant sur le substrat d'AsGa plusieurs puces de silicium de quelques millimètres de côté.

## Revendications

1. Composant semiconducteur hybride comprenant un substrat principal (30) en matériau autre que du silicium, dans lequel sont intégrés d'une part des éléments actifs (31), d'autre part des premiers plots de contact (36) et des connexions (34) entre chaque'élément actif et un plot de contact respectif, et plusieurs puces de circuit intégré en silicium (50 à 55) dans lesquelles sont intégrés d'une part des circuits électroniques destinés à être reliés aux éléments actifs du substrat principal, et d'autre part des seconds plots de contact (58) en regard de ceux du substrat principal, les puces de silicium étant soudées sur le substrat principal par l'intermédiaire desdits premiers et seconds plots de contact (36,58) en regard.

2. Composant hybride selon la revendication 1, caractérisé en ce que le substrat principal comporte des plots de contact d'entrée/sortie (64) situés en dehors de zones recouvertes par les puces de silicium, ces plots servant à la connexion du composant hybride avec l'extérieur.

3. Composant hybride selon la revendication 2, caractérisé en ce que les plots de contact d'entrée/sortie (64) sont reliés, par des connexions (62) intégrées sur le substrat principal, à des plots de contact supplémentaires (37) soudés aux puces de silicium.

4. Composant hybride selon l'une des revendications 1 à 3, caractérisé en ce que les éléments actifs du substrat principal sont répartis sur au moins une ligne, les premiers plots de contact respectifs reliés à ces éléments actifs étant répartis en plusieurs groupes situés en dehors de cette ligne, chaque groupe correspondant à une puce de silicium respective, la taille et le pas des premiers plots de contact dans chaque groupe étant plus grands que la taille et le pas des éléments actifs correspondants.

5. Composant hybride selon l'une des revendications 1 à 4, caractérisé en ce que les éléments actifs sont des éléments photosensibles.

6. Composant hybride selon la revendication 5, caractérisé en ce que les éléments photosensibles sont des détecteurs élémentaires infrarouge.

7. Composant hybride selon la revendication 6, caractérisé en ce qu'il comporte une barrette linéaire ou multilinéaire de détecteurs infrarouge intégrés sur le substrat principal et des circuits de lecture correspondant à chaque détecteur pour lire les charges générées par l'éclairement des détecteurs, ces circuits de lecture étant intégrés sur les puces de silicium.

8. Composant hybride selon l'une des revendications précédentes, caractérisé en ce que les puces de silicium ont des dimensions latérales inférieures à 10 millimètres de côté.

9. Composant hybride selon l'une des revendications précédentes, caractérisé en ce que la soudure des puces de silicium sur le substrat principal se fait par l'intermédiaire de billes d'indium (67) formées sur les premiers et seconds plots de contact en regard.

10. Composant hybride selon l'une des revendications précédentes, caractérisé en ce que le substrat principal est réalisé dans un matériau semiconducteur des classes III-V, Il-VI, ou IV-VI, et notamment l'un des matériaux suivants : GaAs, InP, HgCdTe, PbTe.

11. Utilisation du composant hybride selon l'une des revendications 6 et 7, comme détecteur infrarouge à éclairement par la face avant du substrat principal, la face avant étant celle sur laquelle sont intégrés les éléments actifs et sur laquelle sont soudés les puces de silicium, ces dernières étant disposées de manière à ne pas recouvrir les détecteurs.

## Patentansprüche

1. Hybrid-Halbleiterbauelement mit einem Hauptsubstrat (30) aus einem anderen Material als Silicium, in dem einerseits aktive Elemente (31) und andererseits erste Kontaktstücke (36) und Verbindungen (34) zwischen jedem aktiven Element und einem jeweiligen Kontaktstück integriert sind, und mit mehreren integrierten Schaltungschips (50 bis 55) aus Silicium, in denen einerseits elektronische Schaltungen integriert sind, die dazu bestimmt sind, mit den aktiven Elementen des Hauptsubstrats verbunden zu werden, und andererseits zweite Kontaktstücke (58), die denjenigen des Hauptsubstrats gegenüberliegen, wobei die Siliciumchips auf dem Hauptsubstrat mittels der einander gegenüberliegenden ersten und zweiten Kontaktstücke (36, 58) angelötet sind.

2. Hybrid-Bauelement nach Anspruch 1, dadurch gekennzeichnet, daß das Hauptsubstrat Eingangs-/Ausgangs-Kontaktstücke (64) aufweist, die außerhalb der von den Siliciumchips bedeckten Zonen liegen, wobei diese Kontaktstücke für die Verbindung des Hybrid-Bauelements nach außen dienen.

3. Hybrid-Bauelement nach Anspruch 2, dadurch gekennzeichnet, daß die Eingangs-/Ausgangs-Kontaktstücke (64) durch auf dem Hauptsubstrat integrierte Verbindungen (62) mit zusätzlichen Kontaktstücken (37) verbunden sind, die mit den Siliciumchips verlötet sind.

4. Hybrid-Bauelement nach einem der Ansprüche 1 bis 3, dadurch gekennzeichnet, daß die aktiven Elemente des Hauptsubstrats auf wenigstens einer Zeile verteilt sind, wobei die mit diesen aktiven Elementen verbundenen jeweiligen ersten Kontaktstücke in mehrere Gruppen aufgeteilt sind, die außerhalb dieser Zeile liegen, wobei jede Gruppe jeweils einem Siliciumchip entspricht, wobei die Größe und die Schrittweite der ersten Kontaktstücke in jeder Gruppe größer als die Größe und Schrittweite der entsprechenden aktiven Elemente sind.

5. Hybrid-Bauelement nach einem der Ansprüche 1 bis 4, dadurch gekennzeichnet, daß die aktiven Elemente lichtempfindliche Elemente sind.

6. Hybrid-Bauelement nach Anspruch 5, dadurch gekennzeichnet, daß die lichtempfindlichen Elemente elementare Infrarotdetektoren sind.

7. Hybrid-Bauelement nach Anspruch 6, dadurch gekennzeichnet, daß sie eine lineare oder multilineare Schiene von auf dem Hauptsubstrat integrierten Infrarotdetektoren und Leseschaltungen enthält, die jedem Detektor zum Lesen der durch die Beleuchtung der Detektoren erzeugten Ladungen zugeordnet sind, wobei diese Leseschaltungen auf den Siliciumchips integriert sind.

8. Hybrid-Bauelement nach einem der vorhergehenden Ansprüche, dadurch gekennzeichnet, daß die Siliciumchips seitliche Abmessungen von weniger als 10 mm Seitenlänge haben.

9. Hybrid-Bauelement nach einem der vorhergehenden Ansprüche, dadurch gekennzeichnet, daß das Anlöten der Siliciumchips auf dem Hauptsubstrat mittels Indiumkügelchen (67) erfolgt, die auf den einander gegenüberliegenden ersten und zweiten Kontaktstücken gebildet werden.

10. Hybrid-Bauelement nach einem der vorhergehenden Ansprüche, dadurch gekennzeichnet, daß das Hauptsubstrat aus einem Halbleitermaterial der Klassen III-V, II-VI oder VI-VI und insbesondere aus einem der folgenden Materialien gebildet ist: GaAs, InP, HgCdTe, PbTe.

11. Verwendung des Hybrid-Bauelements nach einem der Ansprüche 6 und 7 als Infrarotdetektor mit Beleuchtung von der Vorderseite des Substrats, wobei die Vorderseite diejenige ist, auf der die aktiven Elemente integriert sind und auf der die Siliciumchips angelötet sind, wobei diese letzteren so angeordnet sind, daß sie die Detektoren nicht bedecken.

## Claims

1. Hybrid semiconductor component comprising a main substrate (30) made of a material other than silicon, in which are integrated, on the one hand, active elements (31) and, on the other hand, first contact pads (36) and connections (34) between each active element and a respective contact pad, and several integrated-circuit silicon chips (50 to 55) in which are integrated, on the one hand, electronic circuits intended to be connected to the active elements of the main substrate and, on the other hand, second contact pads (58) facing those of the main substrate, the silicon chips being bonded to the main substrate via the said first and second facing contact pads (36, 58).

2. Hybrid component according to Claim 1, characterized in that the main substrate includes input/output contact pads (64) located outside the zones covered by the silicon chips, these pads serving for the connection of the hybrid component with the outside.

3. Hybrid component according to Claim 2, characterized in that the input/output contact pads (64) are connected, by connections (62) integrated on the main substrate, to additional contact pads (37) bonded to the silicon chips.

4. Hybrid component according to one of Claims 1 to 3, characterized in that the active elements of the main substrate are distributed along at least one line, the respective first contact pads connected to these active elements being distributed in several groups located outside this line, each group corresponding to a respective silicon chip, the size and pitch of the first contact pads in each group being larger than the size and pitch of the corresponding active elements.

5. Hybrid component according to one of Claims 1 to 4, characterized in that the active elements are photosensitive elements.

6. Hybrid component according to Claim 5, characterized in that the photosensitive elements are infrared elementary detectors.

7. Hybrid component according to Claim 6, characterized in that it includes a linear or multilinear array of infrared detectors integrated on the main substrate and read circuits corresponding to each detector in order to read the charges generated by the illumination of the detectors, these read circuits being integrated on the silicon chips.

8. Hybrid component according to one of the preceding claims, characterized in that the silicon chips have lateral dimensions of less than 10 millimetres a side.

9. Hybrid component according to one of the preceding claims, characterized in that the silicon chips are bonded to the main substrate by means of indium balls (67) formed on the first and second facing contact pads.

10. Hybrid component according to one of the preceding claims, characterized in that the main substrate is made of a semiconductor material of the III-V, II-VI or IV-VI classes, and especially one of the following materials: GaAs, InP, HgCdTe, PbTe.

11. Use of the hybrid component according to one of Claims 6 and 7 as an infrared detector to be illuminated via the front face of the main substrate, the front face being that on which the active elements are integrated and to which the silicon chips are bonded, the latter being arranged so as not to cover the detectors.
